# EUROPEAN PATENT APPLICATION

(11) **EP 3 459 659 A1**
(43) Date of publication of application: **27.03.2019**
(21) Application number: 17885443.6
(22) Date of filing: 29.12.2017
(51) Int. Cl.: B22F 9/08, C23C 14/34

(54) **ALLOY POWDER AND PREPARATION METHOD THEREFOR**

(30) Priority: 04.08.2017 CN 201710661557
(71) Applicant: Miasolé Equipment Integration (Fujian) Co., Ltd., 362000 Quanzhou Fujian (CN)
(72) Inventor: ZENG, Yulin, Quanzhou Fujian 362005 (CN); WAN, Jie, Quanzhou Fujian 362005 (CN); XU, Xiaohua, Quanzhou Fujian 362005 (CN)
(74) Representative: Cabinet Beau de Loménie
(86) International application number: PCT/CN2017/120072
(87) International publication number: WO 2019/024420

(57) **Abstract**

Provided is a method of preparing an alloy powder, comprising the steps of: melting the metal elements for preparing the alloy powder to produce the alloy solution; atomizing the alloy solution into small drops under oxygen-containing atmosphere; forcing the small drops to be quickly cooled under the driving of the atomizing flow to obtain the alloy powder; wherein, when the method is used to prepare Cu-In-Ga alloy powder, Cu/(In+Ga) is 0.5 to 1.1, In/(In+Ga) is 0.2 to 0.9, Ga/(In+Ga) is 0.1 to 0.8, In/(In+Ga) + Ga/(In+Ga) is 1. Also provided is an alloy powder and a method of preparing Cu-In-Ga alloy powder.

## Description

### TECHNICAL FIELD

The present application relates to, but not limited to, the field of solar application materials, and particularly to, but not limited to, an alloy powder and a method for preparing the same.

### BACKGROUND

Copper Indium Gallium Selenide (CIGS) alloy, used in CIGS thin-film solar cells, is a chalcopyrite structured compound semiconductor composed of four elements Cu, In, Ga, Se. Currently, maximizing conversion efficiency of CIGS thin-film solar cells is 22.3%. The CIGS thin-film solar cell is especially attractive for the third generation solar cell investigation and application because of its advantages, such as high conversion efficiency, high power generation performance under weak sunlight, high annual generation capacity and wide applicability for its flexible encapsulation.

CIGS thin-film solar cells have a multilayer film structure, including a metal gate electrode, an anti-reflection film, a window layer (ZnO), a transition layer (CdS), a light absorption layer (CIGS), a metal back electrode (Mo), a glass substrate and so on. Among these layers, the light absorption layer CIGS is most important, and is generally deposited by method of magnetron sputtering using Cu-In-Ga based target materials.

### SUMMARY OF THE INVENTION

Hereinafter, it's a brief summary of the objects of the invention which will be described in the detailed description. Although, it is not intended to limit the scope of the claims.

The inventors of the present invention discovered that Cu-In-Ga alloy has an extensively wide solid-liquid coexisting temperature zone of about 160-500 °C. The alloy will be completely melted above 500 °C and solidified below 160°C. Therefore, significant volume shrinkage usually occurs with the conversion from liquid to solid, which consequently for example causes that Cu-In-Ga alloy target produced by traditional melting and casting method has low density with the generation of considerable shrinkage porosities and cavities, and also has an uneven distribution of the main compositions. Otherwise, the above-mentioned problem may be solved, if Cu-In-Ga alloy powder is prepared and then formed into the target by powder metallurgy method or thermal spray deposition method. However, since the melting points of metal elements (In 156.6□, Ga 29.8□, Cu 1083□) are considerably different, the powder alloy phase is mainly composed of Cu-Ga intermetallic compound and In-based alloy phase. Because of the much lower melting point of In, there exists liquid phases in the alloy powder produced by traditional gas atomization method, which tends to cause severe aggregation and cohesion of the particulates during the cooling process or at the room temperature. Consequently, the surfaces of particulates are attached by a plurality of small satellite particles. As a result, the prepared alloy powder has a quite low yield and poor flowability, so that it may not satisfy the requirements of the process and may not be formed into a target with high performance. Moreover, during the following deposition process, the prepared powder may not be fed fluently, that often make the powder feeding system of a thermal spraying device obstructed.

Similarly, when preparing other alloy powders with extensively wide solid-liquid coexisting temperature zone and even comprising a metal component with much low melting point, the problems described above will also be caused accordingly.

Based on the deep analysis to the above-mention problems, the inventors of the present invention provide a method of preparing an alloy powder with low aggregation and high flowability. The quite lower aggregation and much higher flowability of the alloy powder prepared by the method result in an increase of the yield rate, and are very useful to the following production of the target.

Specifically, the present invention provides an alloy powder, selected from any one of Cu-In-Ga, Ag-In-Ga, Au-In-Ga, Cu-Sn-Ga, Ag-Sn-Ga, Au-Sn-Ga, Cu-Ag-In-Ga and Cu-Au-In-Ga, and having an oxygen concentration below 5000ppm.

According to some embodiments, the alloy powder may have an oxygen concentration in a range from 100ppm to 3000ppm.

According to some embodiments, the alloy powder may have a particle size in a range from 10µm to 50µm or from 30µm to 100µm.

According to some embodiments, based on the atomic ratio, in the Cu-In-Ga alloy powder, Cu/(In+Ga) is 0.5 to 1.1, In/(In+Ga) is 0.2 to 0.9, Ga/(In+Ga) is 0.1 to 0.8, In/(In+Ga)+Ga/(In+Ga) is 1, in which Cu may be partially or totally substituted by Ag or Au, and In may be partially or totally substituted by Sn.

Further, the present invention also provides a method of preparing said alloy powder, comprising the steps of:
Melting metal elements for preparing the alloy powder to produce an alloy solution;
atomizing the alloy solution into small drops in an oxygen-containing atmosphere;
Under the driving of atomizing flow, forcing the small drops to be quickly cooled to obtain the alloy powder.

According to some embodiments, the alloy powder is selected from any one of Cu-In-Ga, Ag-In-Ga, Au-In-Ga, Cu-Sn-Ga, Ag-Sn-Ga, Au-Sn-Ga, Cu-Ag-In-Ga and Cu-Au-In-Ga.

It should be understood that, the method according to the present invention is not limited to prepare the alloy powders exemplified above, and also may be used to prepare other alloy powders. The descriptions, along with the examples of alloy powders, are made only by way of example and are not intended to limit the scope of this invention in any manner. When the melting points of alloy components are distributed in a large temperature range, as described above, resulting in the cohesion among particulates and/or the attachment of satellite particles on the surfaces in the alloy powder if prepared by traditional method, it is especially adapted to use the method according to the present invention.

According to some embodiments, said alloy powder may be Cu-In-Ga alloy powder, in which, based on the atomic ratio, Cu/(In+Ga) may be 0.5 to 1.1, In/(In+Ga) may be 0.2 to 0.9, Ga/(In+Ga) may be 0.1 to 0.8, In/(In+Ga)+Ga/(In+Ga) may be 1.

Optionally, in said Cu-In-Ga alloy powder, Cu may be partially or totally substituted by Ag or Au, and In may be partially or totally substituted by Sn.

According to some embodiments, the metal elements may be melted under vacuum atmosphere below 1000Pa, to produce the alloy solution.

Optionally, the metal elements may be melted under vacuum atmosphere in a range from 50Pa to 500Pa, to produce the alloy solution.

According to some embodiments, the metal elements may be melted at temperature not lower than 650□.

Optionally, the metal elements may be melted at temperature in a range from 750°C to 1050°C.

According to some embodiments, the metal elements may be melted for a period not shorter than 30min.

Further, the present invention also provides a method of preparing Cu-In-Ga alloy powder, comprising the steps of:
Disposing metal elements of In, Cu and Ga into a reactor;
Making the reactor in vacuum state, and then sealing and heating the reactor, to produce an alloy solution by melting said metal elements;
Delivering the alloy solution into atomizing center of an atomization device, meanwhile feeding a flow of high-pressure inert gas and oxygen-containing gas, to make the alloy solution atomized into small drops under the impact of the high-pressure flow;
Under the driving of atomizing flow, forcing the small drops to be quickly cooled, to obtain the alloy powder.

According to some embodiments, based on that the total weight of the metal elements is 100%, the weight of In may be 30% to 70%, the weight of Ga may be 5% to 35%, the weight of Cu may be the balance.

According to some embodiments, each of the components In, Cu and Ga may have a purity not lower than 99.99%.

According to some embodiments, the metal elements may be melted in the reactor under vacuum atmosphere in a range from 50Pa to 500Pa.

According to some embodiments, the metal elements may be melted at temperature in a range from 750°C to 1050°C.

According to some embodiments, the metal elements may be melted for a period not shorter than 30min.

According to some embodiments, the high-pressure inert gas may be N₂ or Ar gas, with the pressure of 0.5MPa to 5MPa and the flow rate of 50m³/h to 500m^{3/}h.

Optionally, the inert gas may have the pressure of 1MPa to 3MPa and the flow rate of 100m³/h to 400m^{3/}h.

According to some embodiments, the oxygen-containing gas may be O₂ gas, compressed air or a combination of O₂ gas and compressed air.

According to some embodiments, both high-pressure inert gas and O₂ gas may be fed into the atomization device at the same time, and the flow rate of O₂ gas may be 10ml/min to 2000ml/min, optionally, 50ml/min to 1000ml/min.

According to some embodiments, both high-pressure inert gas and compressed air may be fed into the atomization device at the same time, and the flow rate of compressed air may be 0.05L/min to 20L/min, in which the pressure of compressed air will not affect the characteristics of the prepared alloy powder, so it is not desired to limit it.

According to some embodiments, both high-pressure inert gas and oxygen-containing gas may be each independently fed into the atomization device at the same time through different pipelines, or alternatively, may be mixed from different pipelines and then fed into the atomization device together.

According to some embodiments, the method may be implemented in a gas atomization powder preparing apparatus, and the reactor may be a vacuum induction melting furnace of the apparatus, in which the pressure difference between the melting chamber and the atomizing chamber of the apparatus may be 500Pa to 0.05MPa.

Optionally, the pressure difference between the melting chamber and the atomizing chamber of the apparatus may be 1000Pa to 1O000Pa.

According to some embodiments, the alloy solution may be delivered into the atomization device though a conducting pipe with the diameter of 0.5mm to 2mm.

According to some embodiments, the high-pressure inert gas and the oxygen-containing gas delivered may be sprayed via a high-pressure gas spray disc of the atomization device.

According to some embodiments, the method may further comprise the steps of collecting and sieving the prepared alloy powder.

Optionally, the step of sieving may be achieved by use of an ultrasonic auxiliary vibration sieve.

Optionally, after the step of sieving, the prepared alloy powder may have a particle size of 10µm to 50µm or 30µm to 100µm.

According to some embodiments, the prepared alloy powder may have an oxygen concentration lower than 5000ppm.

Optionally, the prepared alloy powder may have an oxygen concentration in a range from 100ppm to 3000ppm.

Further, the present invention provides an alloy powder prepared by the method as described above. The alloy powder has a particle size in a range from 10µm to 50µm or 30µm to 100µm, and has an oxygen concentration lower than 5000ppm.

According to some embodiments, the prepared alloy powder has an oxygen concentration in a range from 100ppm to 3000ppm.

Generally, the performance of the film deposited on the target may be affected by the oxygen concentration in the target, and specifically, the performance may be worse with increasing of the oxygen concentration. Therefore, it is desired to decrease the oxygen concentration in the target. However, the inventors of the present invention discovered that, feeding a controlled oxygen-containing gas during the gas atomization preparing process of an alloy powder may induce the generation of the satellite particles, increase the characteristics and the yield rate of the alloy powder, and may make the oxygen concentration in the target controlled to a desired range as well. Although, it is not expected to be limited to the theory, the inventors of the present invention estimate that, the alloy powder is subjected to a surface modification by the controlled oxygen-containing gas, and subsequently a much thinner oxide layer is formed on the surface of the powder and makes the powder passivated, which accordingly decreases the generation of the satellite particles and prevents the occurrence of cohesion during storage and transport of the powder. By use of the method of preparing an alloy powder according to the present invention, the generation of the satellite particles and the occurrence of cohesion in the process of atomizing are significantly decreased, so that the yield rate and the flowability of the powder are increased accordingly. When the prepared alloy powder is subsequently formed into the target (for example, Cu-In-Ga target), the processing behaviors of the target may be considerably improved, and the problems of the delivery of the alloy powder arising during the thermal spraying deposition may be solved as well.

Other features and advantages will be explained in the following description, and will become more obvious partially from the description or be understood by realizing the present invention. The objects and other advantages of the present invention may be achieved via the structure particularly indicated in the specification, the claims and the drawings.

### BRIEF DESCRIPTION OF THE DRAWINGS

A further understanding of the invention may be achieved in conjunction with the accompanying drawings, which constitute a part of the specification and interpret the invention together with the examples, but may not be regarded as a limitation to the invention by any way.
FIG. 1 is a process flow chart for the method of preparing the Cu-In-Ga alloy powder according to Examples of the present invention.
FIGs. 2a, 2b respectively show the morphology of the Cu-In-Ga alloy powder prepared by traditional gas atomization method and prepared according to Example 1 of the present invention.

### DETAILED DESCRIPTION

To make the objects, the technical solutions and the advantages of the invention understood more clearly, the present invention will be described in more detail with reference to the drawings. It is noted that, the Examples and the features referred in the Examples may be arbitrarily combined with each other.

The parameters measured in the Examples below are determined by conventional methods in the art, except otherwise indicated.

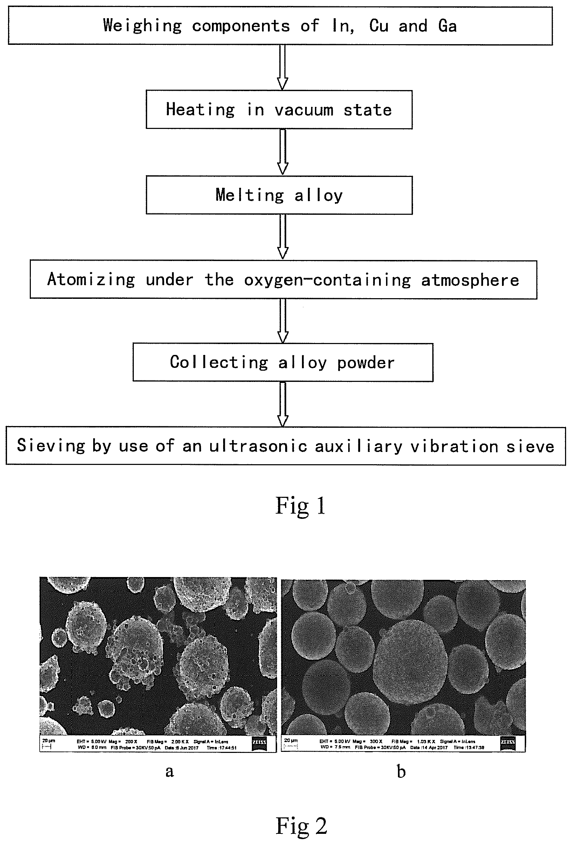

As shown in FIG.1, the method of preparing the Cu-In-Ga alloy powder according to the Examples below comprises the steps of :
Weighing the components of In, Cu and Ga in proportion;
Disposing the weighed components into a reactor, making the reactor in vacuum state, and then sealing and heating the reactor;
Melting the components, to produce the alloy solution;
Atomizing the alloy solution into small drops under the oxygen-containing atmosphere, and forcing the small drops to be quickly cooled, to obtain the alloy powder;
Collecting the alloy powder;
Sieving the alloy powder by use of an ultrasonic auxiliary vibration sieve.

### Example 1

(1) weighing 50kg In, 35kg Cu and 15kg Ga (purity 99.9999%, commercially available products) respectively, i.e. based on the atomic ratio, Cu/(In+Ga) is 0.86, In/(In+Ga) is 0.67, Ga/(In+Ga) is 0.33;
(2) conducting the steps of melting and atomizing in a gas atomization powder preparing apparatus to prepare the alloy powder.
   The gas atomization powder preparing apparatus includes a main part, in which a vacuum chamber and an atomizing chamber are disposed in sequence from top to bottom, and connected to each other via an intermediate package with liquid metal pipelines. The vacuum chamber has a melting device and a heating device disposed therein, and the heating device heats the melting device. The melting device has an outlet connected to the top of the atomizing chamber via a conducting pipe. The atomizing chamber has a gas nozzle connected to a high-pressure inert gas pipeline, and the gas nozzle ejects out high-pressure inert gas toward outlet of the conducting pipe. The atomizing chamber has an oxygen-containing gas pipeline and a spraying device connected with each other. The oxygen-containing gas pipeline delivers the oxygen-containing gas into the atomizing chamber though the spraying device.
   The components described above are disposed into a crucible of the melting chamber. Subsequently, the power is turned on, and the melting chamber is vacuumized to a pressure of 200Pa. The components are melted by heating at 900°C for 60min to obtain an uniform alloy solution with electromagnetic stirring of an induction coil. Then, the vacuum pump is turned off. N₂ gas is fed into the melting chamber and the atomizing chamber, to make the pressure of the atomizing chamber to be atmospheric pressure and 2000Pa lower than that of the melting chamber.
(3) The melted alloy solution is poured slowly and evenly into the intermediate package, and then, under the gravity and the pressure difference (9000Pa) between the vacuum melting chamber and the atomizing chamber, flows toward the atomizing chamber via the liquid metal conducting pipe with the diameter of 2mm. Meanwhile, N₂ gas, with the pressure of 3MPa and the flow rate of 200m³/h, is fed into the atomizing chamber through the high-pressure inert gas pipeline as an atomizing medium, and at the same time, clean compressed air, with the pressure of 0.8MPa and the flow rate of 3L/min, is fed into the atomizing chamber through the oxygen-containing gas pipeline. Immediately after the alloy solution exits from the end of the conducting pipe, it is atomized into small drops under the impact of the high-pressure flow. The small drops are forced to be cooled quickly under the driving of the atomizing flow, to obtain the alloy powder. The whole atomization process is accomplished for about 1 hour.
(4) The alloy powder prepared in the gas atomization preparing apparatus is collected and then sieved by an ultrasonic auxiliary vibration sieve to obtain the Cu-In-Ga alloy powder with the particle size of 30µm to 100µm, which is desired to form the Cu-In-Ga target.

The yield rate of the Cu-In-Ga alloy powder is not lower than 98%, and the yield rate of the powder with the particle size of 30µm to 100µm is 44%. The prepared powder shows a good flowability of 14s/50g tested by Hall flow meter, so that no obvious aggregation and cohesion among the particulates of the powder exist. The oxygen concentration of the powder is 300ppm.

### Example 2

(1) weighing 35kg In, 40kg Cu and 25kg Ga (purity 99.999%, commercially available products) respectively, i.e. based on the atomic ratio, Cu/(In+Ga) is 0.95, In/(In+Ga) is 0.46, Ga/(In+Ga) is 0.54;
(2) conducting the steps of melting and atomizing in the gas atomization powder preparing apparatus as described in Example 1 to prepare the alloy powder. The components described above are disposed into the crucible of the melting chamber. Subsequently, the power is turned on, and the melting chamber is vacuumized to the pressure of 500Pa. The components are melted by heating at 1000°C for 40min to obtain an uniform alloy solution with electromagnetic stirring of an induction coil.
(3) The melted alloy solution is poured slowly and evenly into the intermediate package, and then, under the gravity and the pressure difference (20000Pa) between the vacuum melting chamber and the atomizing chamber, flows toward the atomizing chamber via the liquid metal conducting pipe with the diameter of 1.5mm. Meanwhile, N₂ gas, with the pressure of 2MPa and the flow rate of 120m³/h, is fed into the atomizing chamber through the high-pressure inert gas pipeline as an atomizing medium, and at the same time, O₂ gas, with the pressure of 0.8MPa and the flow rate of 500ml/min, is fed into the atomizing chamber through the oxygen-containing gas pipeline. Immediately after the alloy solution exits from the end of the conducting pipe, it is atomized into small drops under the impact of the high-pressure flow. The small drops are forced to be cooled quickly under the driving of the atomizing flow, to obtain the alloy powder.
(4) The alloy powder prepared in the gas atomization preparing apparatus is collected and then sieved by an ultrasonic auxiliary vibration sieve to obtain the Cu-In-Ga alloy powder with the particle size of 30µm to 100µm, which is desired to form the Cu-In-Ga target.

The yield rate of the Cu-In-Ga alloy powder is not lower than 98%, and the yield rate of the powder with the particle size of 30µm to 100µm is 45%. The prepared powder shows a flowability of 18s/50g tested by Hall flow meter, so that no obvious aggregation and cohesion among the particulates of the powder exist. The oxygen concentration of the powder is 420ppm.

### Examples 3 to 7

Parts of the process parameters of Examples 3 to 7 are shown in Table 1, and other steps and process parameters are similar as Example 1.

**Table 1**

| | Example 3 | Example 4 | Example 5 | Example 6 | Example 7 |
|---|---|---|---|---|---|
| melting temperature, °C | 900 | 950 | 1050 | 750 | 800 |
| flow rate of N₂ gas, m³/h | 200 | 180 | 300 | 350 | 150 |
| pressure of N₂ gas, MPa | 3 | 3.5 | 1 | 2 | 2 |
| flow rate of compressed air, L/min | 16 | 0.1 | 5 | 5 | 2 |
| diameter of liquid metal conducting pipe, mm | 2 | 0.5 | 1.5 | 1 | 2 |
| yield rate of the powder with a particle size of 30 to 100µm, % | 44 | 33 | 40 | 37 | 42 |
| flowability of the powder, s/50g | 25 | 19 | 16 | 14 | 13 |
| oxygen concentration of the powder, ppm | 1480 | 120 | 380 | 280 | 230 |

### Comparative Example 1

Comparative Example 1 is similar as Example 1, except that no compressed air is fed during the atomizing process.

The yield rate of the Cu-In-Ga alloy powder is 98%, and the yield rate of the powder with the particle size of 30µm to 100µm is 20%. The prepared powder shows a poor flowability of 30s/50g tested by Hall flow meter, resulting in the occurrence of aggregation and cohesion among the particulates of the powder and the generation of considerable satellite particles.

### Characteristic tests

1. The Cu-In-Ga alloy powder prepared respectively according to Example 1 and Comparative Example 1 were observed under the scanning electron microscope. The results were shown in FIG.2.
   It may be noted that, the Cu-In-Ga alloy powder prepared in Comparative example 1 had a large number of small satellite particles attached to the surfaces of the particulates, and there also existed cohesion among the particulates. While, the Cu-In-Ga alloy powder prepared in Example 1 had the spherical particulates with smooth surfaces and quite few small satellite particles attached thereon.
2. By conventional plasma spraying method in the art, the Cu-In-Ga alloy powder prepared according to Examples 1 to 7 was formed into the Cu-In-Ga targets, with the thickness of 7mm, the relative density of 95%, the purity higher than 99.99% and the oxygen concentration not higher than 3000ppm. When used as the sputtering targets in the production of Cu-In-Ga-Se thin film solar cells, the formed targets had a stable plasma arcing and no irregular discharge, satisfying the desired characteristic requirements.

The present disclosure is an illustration of the principle of the embodiments according to the present invention, but not intended to do any formal or substantial limitation to the present invention, or limit the present invention to specific embodiments. For those skilled in the art, it is obvious that the elements, methods and systems of the technical solutions in the embodiments of the present invention may be changed, altered, modified and evolved, without departing from the principle, spirit and scope as defined in the claims of the embodiments and technical solutions of the present invention as described above. These changed, altered, modified and evolved embodiments are all included in the equivalent embodiments of the present invention, and these equivalent embodiments are all included in the scope of the present invention defined by the claims. Although embodiments of the present invention may be embodied in many different forms, some embodiments of the present invention are described in detail herein. Furthermore, embodiments of the present invention include any possible combination of some or all of the various embodiments described herein, as well as within the scope of the present invention as defined by the claims. All patents, patent applications and other cited articles mentioned anywhere in the present invention or in any cited patent, cited patent application, or other cited articles are hereby incorporated by reference in their entirety.

The above disclosure is intended to be illustrative and not exhaustive. For those skilled in the art, this specification will suggest many changes and alternatives. All these alternatives and variations are intended to be included within the scope of the claims, where the term "comprising" means "including, but not limited to".

The description of alternative embodiments of the present application is concluded herein. Those skilled in the art will recognize other equivalent variations of the embodiments described herein, which equivalents are also included by the claims attached hereto.

### Industrial Applicability

Using the method of preparing the alloy powder provided by the present invention, the yield and the qualification of the alloy powder may be improved, and the prepared alloy powder has the advantages of less surface satellite particles, less occurrence of cohesion, and better flowability.

## Claims

1. An alloy powder, selected from any one of Cu-In-Ga, Ag-In-Ga, Au-In-Ga, Cu-Sn-Ga, Ag-Sn-Ga, Au-Sn-Ga, Cu-Ag-In-Ga and Cu-Au-In-Ga alloy powders, with oxidized particulate surfaces and an oxygen concentration lower than 5000ppm.

2. The alloy powder according to claim 1, wherein the alloy powder has an oxygen concentration in a range from 100ppm to 3000ppm, and optionally has a particle size in a range from 10µm to 50µm or 30µm to 100µm.

3. The alloy powder according to claim 1 or 2, wherein, based on the atomic ratio, Cu/(In+Ga) is 0.5 to 1.1, In/(In+Ga) is 0.2 to 0.9, Ga/(In+Ga) is 0.1 to 0.8, In/(In+Ga) + Ga/(In+Ga) is 1, and Cu may be partially or totally substituted by Ag or Au, In may be partially or totally substituted by Sn.

4. A method of preparing an alloy powder, comprising the steps of:
melting metal elements for preparing the alloy powder to produce an alloy solution;
atomizing the alloy solution into small drops under oxygen-containing atmosphere;
under the driving of atomizing flow, forcing the small drops to be quickly cooled, to obtain the alloy powder.

5. The method according to claim 4, wherein the alloy powder is selected from any one of Cu-In-Ga, Ag-In-Ga, Au-In-Ga, Cu-Sn-Ga, Ag-Sn-Ga, Au-Sn-Ga, Cu-Ag-In-Ga and Cu-Au-In-Ga, and optionally, based on the atomic ratio, Cu/(In+Ga) is 0.5 to 1.1, In/(In+Ga) is 0.2 to 0.9, Ga/(In+Ga) is 0.1 to 0.8, In/(In+Ga) + Ga/(In+Ga) is 1, Cu may be partially or totally substituted by Ag or Au, and In may be partially or totally substituted by Sn.

6. The method according to claim 4 or 5, wherein the metal elements are melted under vacuum atmosphere below 1000Pa, optionally, in a range from 50Pa to 500Pa, to produce the alloy solution.

7. The method according to any one of claims 4 to 6, wherein the metal elements are melted at temperature not lower than 650°C, optionally in a range from 750°C to 1050°C, and optionally for a period not shorter than 30min.

8. A method of preparing Cu-In-Ga alloy powder, comprising the steps of:
disposing metal elements of Cu, In and Ga into a reactor;
making the reactor in vacuum state, and then sealing and heating the reactor, to produce an alloy solution by melting the metal elements;
delivering the alloy solution into atomizing center of an atomization device, meanwhile, feeding a flow of high-pressure inert gas and oxygen-containing gas, to make the alloy solution atomized into small drops under the impact of the high-pressure inert gas;
under the driving of the atomizing flow, forcing the small drops to be quickly cooled, to produce the alloy powder.

9. The method according to claim 8, wherein, based on that the total weight of the metal elements is 100%, the weight of In is 30% to 70%, the weight of Ga is 5% to 35%, and the weight of Cu is the balance, and optionally, each of the components In, Cu and Ga has a purity not lower than 99.99% and is melted in the reactor under vacuum atmosphere in a range from 50Pa to 500Pa at a temperature in a range from 750°C to 1050 °C for a period not shorter than 30min.

10. The method according to claim 8 or 9, wherein the high-pressure inert gas is N₂ or Ar gas with the pressure of 0.5MPa to 5MPa and the flow rate of 50m³/h to 500m^{3/}h, and optionally, with the pressure of 1MPa to 3MPa and the flow rate of 100m³/h to 400m^{3/}h.

11. The method according to any one of claims 8 to 10, wherein the oxygen-containing gas is O₂, compressed air or a combination of O₂ and compressed air, and optionally, both high-pressure inert gas and O₂ gas are fed into the atomization device at the same time with the flow rate of O₂ gas in a range from 10ml/min to 2000ml/min, further optionally, 50ml/min to 1000ml/min, or both high-pressure inert gas and compressed air are fed into the atomization device at the same time with the flow rate of compressed air in a range from 0.05L/min to 20L/min.

12. The method according to any one of claims 8 to 11, wherein both high-pressure inert gas and oxygen-containing gas are each independently fed into the atomization device at the same time through different pipelines, or mixed from different pipelines and then fed into the atomization device together.

13. The method according to any one of claims 8 to 12, wherein the method is implemented in a gas atomization powder preparing apparatus, the reactor is a vacuum induction melting furnace of the apparatus, and the pressure difference between the melting chamber and the atomizing chamber of the apparatus is 500Pa to 0.05MPa, optionally, 1000Pa to 10000Pa, and optionally, the alloy solution is delivered into the atomization device though a conducting pipe with the diameter of 0.5mm to 2mm, and the high-pressure inert gas and the oxygen-containing gas delivered are sprayed via a high-pressure gas spray disc of the atomization device of the apparatus.

14. The method according to any one of claims 8 to 13, wherein the method further comprise the steps of collecting and sieving the prepared alloy powder, optionally, by use of an ultrasonic auxiliary vibration sieve, and optionally, after the step of sieving, the prepared alloy powder has a particle size of 10µm to 50µm or 30µm to 100µm.

15. The method according to any one of claims 8 to 14, wherein the prepared alloy powder has an oxygen concentration lower than 5000ppm, optionally, in a range from 100ppm to 3000ppm.

16. An alloy powder, prepared by the method according to any one of claims 4 to7, with a particle size of 10µm to 50µm or 30µm to 100µm and an oxygen concentration lower than 5000ppm.

17. The alloy powder according to claim 16, wherein the oxygen concentration is 100ppm to 3000ppm.

18. An alloy powder, prepared by method according to any one of claims 8 to 15.
